(19) **Europäisches Patentamt**
**European Patent Office**
**Office européen des brevets**

(11) **EP 4 678 315 A1**

(12) **EUROPEAN PATENT APPLICATION**
published in accordance with Art. 153(4) EPC

(43) Date of publication:
**14.01.2026 Bulletin 2026/03**

(21) Application number: **24767046.6**

(22) Date of filing: **01.03.2024**

(51) International Patent Classification (IPC):
**B23B 27/14** (2006.01)    **C23C 16/30** (2006.01)

(52) Cooperative Patent Classification (CPC):
**B23B 27/14; C23C 16/30**

(86) International application number:
**PCT/JP2024/007736**

(87) International publication number:
**WO 2024/185678 (12.09.2024 Gazette 2024/37)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.03.2023 JP 2023034690**

(71) Applicant: **Mitsubishi Materials Corporation Tokyo 100-8117 (JP)**

(72) Inventors:
• **ASARI, Shota**
  **Tokyo 100-8117 (JP)**
• **NAKAMURA, Hiroki**
  **Tokyo 100-8117 (JP)**

(74) Representative: **Gille Hrabal Partnerschaftsgesellschaft mbB Patentanwälte Brucknerstraße 20 40593 Düsseldorf (DE)**

(54) **SURFACE-COATED CUTTING TOOL**

(57) A surface coated cutting tool with high durability in high feed cutting of austenitic stainless steel includes an A layer, a B layer, and a C layer on a substrate; the sum of the average thicknesses of these layers ranges from 0.7 to 21.0 $\mu$m; the A layer contains nitride or carbonitride of Ti; the B layer has an average composition $(Al_{XC}Ti_{1-XC})(C_{YC}N_{1-YC})$ (0.65 ≤ XC ≤0.90, 0.00 ≤ YC < 0.05), and contains at least 30 area % crystal grains having a wurtzite-type hexagonal crystal structure and the balance being crystal grains having a NaCl-type face-centered cubic crystal structure; and the C layer has an average composition $(Al_{XC}Ti_{1-XC})(C_{YC}N_{1-YC})$ (0.65 ≤XC ≤0.90, 0.00≤YC < 0.05), and contains 5 to 25 area % crystal grains having a wurtzite-type hexagonal crystal structure and the balance being crystal grains having a NaCl type face-centered cubic crystal structure.

[Fig. 1]

## Description

Technical Field

The present invention relates to surface coated cutting tools (hereinafter also referred to as "coated tools"). This application claims priority based on Japanese Patent Application No. 2023-34690 filed on March 7, 2023. The entire description in the Japanese patent application is hereby incorporated by reference.

Background Art

Coated tools are known that include coating segments formed on the surfaces of substrates composed of, for example, tungsten carbide (hereinafter referred to as "WC") based cemented carbide, in order to improve the life of the cutting tools. These coated tools have improved wear resistance.

In addition, various proposals have been made regarding the composition and structure of the coating segment to further improve the cutting performance of the coated tool.

For example, Patent Literature 1 discloses a surface cutting tool that includes a substrate and a coating layer on the surface of the substrate. The coating layer contains two first crystal phases and a second crystal phase positioned between the first crystal phases. The two first crystal phases each independently includes an alternating laminate configuration of $Ti_{1-x1}Al_{x1}N$ subphases having a sodium chloride-type crystal structure and $Al_{x2}Ti_{1-x2}N$ subphases having a zinc sphalerite-type crystal structure, where x1 satisfies the relation $0.1 \leq x1 \leq 0.7$, and x2 satisfies the relation $0.7 < x2 \leq 0.95$. The second crystal phase comprises AlN having a wurtzite-type crystal structure. The coated tool has a long life in cutting of, for example, high-carbon chromium bearing steel and cast iron.

Patent Literature 2 discloses a surface coated cutting tool that includes a substrate and a coating layer. The coating layer has a laminate structure including a TiAlCN layer $\alpha$ containing more than 70 area% crystal grains having a wurtzite-type hexagonal crystal structure adjacent to the surface of the tool and a TiAlCN layer $\beta$ containing more than 70 area % crystal grains having a NaCl-type face-centered cubic structure adjacent to the substrate. The TiAlCN layer $\alpha$ has a composition $(Ti_{(1-x\alpha)}Al_{x\alpha})(C_{y\alpha}N_{(1-y\alpha)})$, where $0.70 \leq x\alpha \leq 0.95$ and $0.000 \leq y\alpha \leq 0.010$. The TiAlCN layer $\beta$ has a composition $(Ti_{(1-x\beta)}Al_{x\beta})(C_{y\beta}N_{(1-y\beta)})$, where $0.65 \leq x\beta \leq 0.95$ and $0.000 \leq y\beta \leq 0.010$. The TiAlCN layer $\alpha$ and the TiAlCN layer $\beta$ have average thicknesses of L$\alpha$ and L$\beta$, respectively, where $0.5 \ \mu m \leq L\alpha \leq 10.0 \ \mu m$ and $1.0 \ \mu m \leq L\beta \leq 20.0 \ \mu m$. The coated cutting tool has a long life even in high-speed intermittent cutting of cast iron.

Citation List

Patent Literature

PTL1: Japanese Patent No. 6349581
PTL 2: Japanese Unexamined Patent Publication No. 2020-104255

Summary of Invention

Technical Problem

The durability of coated tools is required not only for cutting of high-carbon chromium bearing steel and ductile cast iron, but also for high-feed cutting of difficult-to-cut materials, such as austenitic stainless steel.

An object of the present invention, which has been made in view of the aforementioned circumstances and the aforementioned proposal, is to achieve a surface coated cutting tool that has high durability (long life) even in high-feed cutting operations on austenitic stainless steel, for example.

Summary of Invention

Solution to Problem

A surface coated cutting tool in accordance with the present invention comprises a substrate and a coating segment on the surface of the substrate, wherein

(a) the coating segment comprises an A layer, a B layer, and a C layer, in contact with each other in order from the surface of the substrate to the surface of the tool, and the sum of the average thicknesses of these three layers ranges from 0.7 to 21.0 $\mu$m,

(b) the A layer has an average thickness in a range of 0.1 to 2.0 $\mu$m and contains nitride or carbonitride of Ti,

(c) the B layer has an average thickness in a range of 0.1 to 0.5 $\mu$m, has an average composition represented by $(Al_{XB}Ti_{1-XB})(C_{YB}N_{1-YB})$ (where $0.80 \leq XB \leq 0.95$ and $0.00 \leq YB < 0.05$), and contains at least 30 area % crystal grains having a wurtzite-type hexagonal crystal structure and the balance being crystal grains having a NaCl-type face-centered cubic crystal structure, in the cross-section of the B layer and

(d) the C layer has an average thickness in a range of 0.5 to 20.0 $\mu$m, has an average composition represented by $(Al_{XC}Ti_{1-XC})(C_{YC}N_{1-YC})$ (where $0.65 \leq XC \leq 0.90$ and $0.00 \leq YC < 0.05$), and contains 5 to 25 area % crystal grains having a wurtzite-type hexagonal crystal structure and the balance being crystal grains having a NaCl type face-centered cubic crystal structure in the cross-section of the C layer.

The surface coated cutting tool in accordance with the present invention may satisfy Item (1):

(1) In the coating segment, the intensity Ic(111) of the 111 diffraction line and the intensity Ic(200) of the 200 diffraction line of the crystal grains of the NaCl type face-centered cubic crystal structure, and the intensity Ih(100) of the 100 diffraction line of the crystal grains of the wurtzite-type hexagonal crystal structure satisfy the relation:

$$0.1 \leq \text{Ih}(100)/[\text{Ic}(111)+\text{Ic}(200)] \leq 0.4.$$

Advantageous Effects of Invention

The surface coated cutting tool of the embodiment has high durability even in high-feed cutting operations on austenitic stainless steel, for example. Brief Description of Drawing

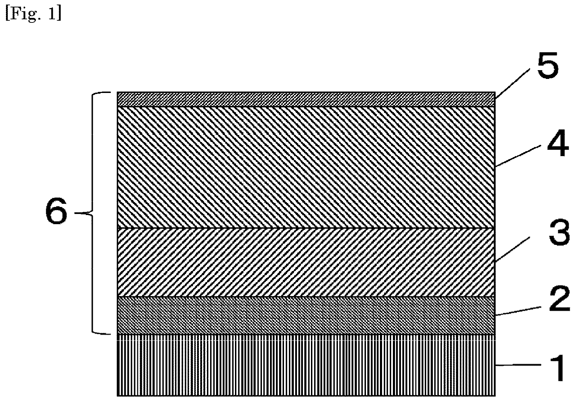

Figure 1 is a schematic diagram of an exemplary cross-sectional view of a surface coated cutting tool of an embodiment of the present invention. Description of Embodiments

The inventor has been extensively studying ways to suppress detachment of the coating segment of a coated tool having a composite carbide layer or a composite carbonitride layer of Al and Ti (hereinafter referred to as (AlTi)CN layer), especially in high feed cutting, which is, cutting at a feed rate several times higher than the normal feed rate.

As a result, the inventor found that a cutting tool including a substrate and a coating segment having the following requirements exhibits improved durability: The coating segment includes an A layer, a B layer, and a C layer disposed from the surface of the substrate to the substrate of the tool and in contact with each other; the A layer includes a Titanium nitride or titanium carbonitride layer, the B layer includes an (AlTi)CN layer, and the C layer includes an (AlTi)CN layer; the B layer and the C layer each have a predetermined composition; and the B and C layers each contain a predetermined percentage of crystal grains with a wurtzite-type hexagonal crystal structure.

A coated tool of the embodiment of the present invention will now be described in detail.

Throughout the specification and the claims, the numerical range expressed as "L to M" (L and M are both numerical values) includes the upper limit (M) and the lower limit (L). When a unit is stated only for the upper limit, the upper (M) and lower (L) limits have the same unit.

The outline of the embodiment of the present invention will now be described with reference to Figure 1.

Figure 1 is a schematic illustration of a cross-section (a cross-section perpendicular to the surface of the substrate where the surface of the substrate is regarded as a horizontal plane without minute irregularities on the surface of the substrate) of a coated tool according to an embodiment of the present invention. As can be seen in Figure 1, the coated tool of this embodiment includes an A layer (2) in contact with the surface of the substrate (1), a B layer (3) in contact with a surface, adjacent to the surface of the tool, of the A layer (2), and a C layer (4) in contact with a surface, adjacent to the surface of the tool, of the B layer (3). The coating segment (6) may also include an outermost layer (5), which will be described below, in addition to the A layer (2), the B layer (3), and the C layer (4).

These layers will now be described in sequence.

1. Coating segment

Among the coating segments, the sum of the average thicknesses (average total thickness) of the A layer (2), B layer (3), and C layer (4) should preferably ranges from 0.7 to 21.0 $\mu$m for the following reasons: A total average thickness of less than 0.7 $\mu$m leads to insufficient wear resistance, whereas a total average thickness exceeding 21.0 $\mu$m causes delamination or defects in the coating segment to occur due to internal defects in each layer in the coating segment.

2. A layer

The A layer in contact with the surface of the substrate contains titanium nitride or titanium carbonitride and acts as an adhesive layer that provides adhesion between the substrate and the B layer.

(1) Average composition

The A layer may have any composition containing titanium nitride or titanium carbonitride. For example, the A layer may be represented by the formula $TiC_ZN_{1-Z}$ where $0.00 \leq Z \leq 0.05$. A Z value of more than 0.05 may cause the hardness of the A layer to increase excessively, resulting in a decrease in toughness and ready detachment of the A layer from the interface with the substrate.

(2) Average thickness

The A layer should preferably have an average thickness in a range of 0.1 to 2.0 $\mu$m for the following reasons: An average thickness of less than 0.1 $\mu$m cause the A layer to work insufficiently as an adhesion layer, whereas an average thickness exceeding 2.0 $\mu$m leads to insufficient wear resistance. The average thickness of the A layer should be more preferably 0.5 to 1.5 $\mu$m.

3. B layer

The B layer, which is in contact with the surface of the A layer, is composed of (AlTi)CN that can suppress cracking and the destruction of the coating segment caused by slight plastic deformation of the substrate due to heat or impact during cutting.

(1) Average composition

The B layer should preferably have an average composition represented by $(Al_{XB}Ti_{1-XB})(C_{YB}N_{1-YB})$ where $0.80 \leq XB \leq 0.95$ and $0.00 \leq YB < 0.05$ for the following reasons:
An XB value of less than 0.80 leads to excess hardness of the (AlTi)CN layer due to a higher percentage of crystal grains having a NaCl-type face-centered cubic structure and insufficient roughness, resulting in insufficient suppression in destruction of the coating segment. An XB value exceeding 0.95 leads to insufficient adhesion with the C layer and ready detachment of the C layer. The XB value is more preferably $0.85 \leq XB \leq 0.90$.
The C component in (AlTi)CN may be included because it has the effect of increasing the hardness of the B layer. Since a YB value of 0.05 or more causes the high-temperature strength of the B layer to decrease, the upper limit of YB should preferably be less than 0.05.
The ratio of $(Al_{XB}Ti_{1-XB})$ to $(C_{YB}N_{1-YB})$ should not be limited to the stoichiometric composition. The acceptable range of the ratio of $(Al_{XB}Ti_{1-XB})$ to $(C_{YB}N_{1-YB})$ may be 0.8 to 1.2.
This holds for $(Al_{XC}Ti_{1-XC})(C_{YC}N_{1-YC})$ in the C layer.

(3) Average thickness

The B layer should preferably has an average thickness in a range of 0.1 to 0.5 $\mu$m for the following reasons: A thickness of less than 0.1 $\mu$m causes the suppression of crack propagation to be insufficient, whereas a thickness exceeding 0.5 $\mu$m causes the wear resistance of the B layer to decrease and damage originating from the B layer to be more likely to occur. The average thickness of the B layer should more preferably be 0.1 to 0.3 $\mu$m.

(4) Hexagonal crystal grains of wurtzite type

The B layer should preferably contain at least 30 area % crystal grains having a wurtzite-type hexagonal crystal structure in its cross-section for the following reasons: An area percentage of less than 30 area% leads to high hardness, insufficient toughness, and reduced adhesion to the C Layer. A more preferably lower limit is 50 area %.
The upper limit of the percentage of crystal grains with a wurtzite-type hexagonal crystal structure is not limited (100 area % is acceptable). In one example of a method of the production described below, the upper limit is about 90 area %.
The crystal structure other than the crystal grains with wurtzite-type hexagonal crystal structure is a NaCl-type face-centered cubic crystal structure.

4. C layer

The C layer, which is deposited on the surface of the B layer, has wear resistance and acts as a layer that inhibits the adhesion of welded materials during cutting.

(1) Average composition

The C layer should preferably have an average composition represented by the formula: $(Al_{XC}Ti_{1-XC})(C_{YC}N_{1-YC})$ where $0.65 \leq XC \leq 0.90$ and $0.00 \leq YC < 0.05$ for the following reasons: An XC value of less than 0.65 causes (AlTi)CN not to fully demonstrate the oxidation resistance. An XC value exceeding 0.90 leads to low hardness of the C layer. The XC value more preferably has the relation: $0.70 \leq XC \leq 0.85$.

The C component in (AlTi)CN may be included because it has the effect of increasing the hardness of the C layer. Since a YC value of 0.05 or more leads to a decrease in the high-temperature strength of the C layer, the upper limit of the YC value is preferably less than 0.05.

(2) Average thickness

The C layer should preferably have an average thickness in a range of 0.5 to 20.0 $\mu$m for the following reasons: A thickness of less than 0.5 $\mu$m leads to insufficient abrasion resistance and insufficient suppression in welding. A thickness exceeding 20.0 $\mu$m facilitates fracture over the entire coating segment starting from cracks on the surface of the coating segment. The average thickness of the C layer should more preferably be 3.0 to 15.0 $\mu$m.

(3) Hexagonal crystal grains of wurtzite-type structure

The C layer should preferably contain 5 area % or more and 25 area % or less crystal grains having a wurtzite-type hexagonal crystal structure in the cross-section for the following reason: In the case that the percentage of crystal grains with a wurtzite-type hexagonal crystal structure is less than 5 area %, adhesion with the B layer is not sufficient, resulting in fracture of the coating segment from the interface with the B layer. In the case that the percentage exceeds 25 area %, the C layer does not have sufficient hardness, resulting in decreased wear resistance. The percentage of wurtzite-type hexagonal crystal grains is more preferably in a range of 10 area % to 20 area %.

It is noted that the crystal structure other than the crystal grains with a wurtzite-type hexagonal crystal structure is a NaCl-type face-centered cubic crystal structure.

5. Other layers

Other layers include those that may be intentionally deposited and those that are not intentionally deposited (layers that may occur unintentionally).

(1) Layer that may be intentionally deposited

An outermost layer, described below, may be intentionally deposited.

The outermost surface layer may be optionally provided on the upper surface of the C layer (in other words, the outermost surface layer is not essential). For example, the outermost layer may be a TiN layer (the atomic ratio of Ti to N in the TiN layer is not limited to stoichiometric). Since the TiN layer, which has a golden color tone, a change in the color tone functions, for example, as an identification layer to determine whether the coated tool has not been used or has been used. The TiN layer as the identification layer has an average thickness of, for example, 0.1 to 1.0 $\mu$m.

(2) Layers not intentionally deposited (layers that may occur unintentionally)

In the embodiment, the deposition is controlled such that layers other than the A, B, C, and topmost surface layers are not deposited, in other words, these layers are deposited in contact with each other. However, an unintended fluctuation in pressure or temperature in the deposition system may occur during switching of deposition of the layers, resulting in the formation of unintended layers different from these layers.

6. Substrate

(1) Material

The substrate used in the embodiment may be composed of any material to achieve the aforementioned purpose. Examples of such material include cemented carbides (WC-based cemented carbide, which contains Co in addition to WC and also includes carbides such as Ti, Ta, and Nb), cermets (mainly composed of TiC, TiN, and TiCN), ceramics (titanium carbide, silicon carbide, silicon nitride, aluminum nitride, and aluminum oxide), and other materials..

(2) Shape

The substrate may have any shape usable as a cutting tool. Examples of the cutting tool include inserts and drills.

7. Measurement

(1) Measurement of boundaries, average thickness, and composition of each layer, and crystal structure and area ratio of crystal grains

The grain boundaries of the crystal grains constituting the (AlTi)CN layer are determined and the crystal grains are identified in the following manner. A polished surface of a substrate is precession-irradiated with an electron beam inclined at 0.5 to 1.0 degree, for example, with respect to the normal direction of the polished cross-section with a crystal orientation analyzer attached to a transmission electron microscope (TEM). The electron beam scans at arbitrary beam diameters and intervals to continuously capture electron diffraction patterns and analyze the crystal orientation of individual measurement points. The field of view is 50 $\mu$m in width in the direction parallel to the surface of the substrate (transverse direction) and the thickness of the coating segment (average thickness) in the longitudinal direction.

The electron diffraction pattern used in this measurement was acquired under the conditions of, for example, an acceleration voltage of 200 kV, a camera length of 20 cm, a beam size of 2.4 nm, and a measurement step of 5.0 nm. The measured crystal orientation was examined discretely on the plane of the measurement, and the orientation distribution of the entire measurement plane was obtained by representing the area up to the middle between adjacent measurement points with the results of the measurement. A regular hexagonal shape can be used as an example of the area represented by these points of the measurement (hereinafter referred to as "pixel").

If the angular difference in crystallographic orientation is 5 degrees or more between adjacent pixels, or if only one of the adjacent pixels shows a NaCl-type face-centered cubic structure or a wurtzite-type hexagonal structure, the edge of the area where these pixels in contact with each other is defined by a grain boundary. The area enclosed by the edges that are defined by grain boundaries is defined as one crystal grain. However, pixels that exist alone, such as those that have an orientation difference of 5 degrees or more from all adjacent pixels, or those that have no adjacent measuring points with a NaCl-type face-centered cubic structure, are not considered to be crystal grains, and two or more pixels that are connected to each other are defined as crystal grains. In this way, grain boundaries are determined to identify crystal grains.

For the analysis, the boundary between adjacent measuring points (pixels) with an orientation difference of 5 degrees or more is defined as a grain boundary. However, a single pixel that has an orientation difference of 5 degrees or more from all adjacent pixels is not defined as a grain, and two or more connected pixels are defined as a grain.

By determining each grain and differentiating its crystal structure in this way, the area fraction of crystal grains with a wurtzite-type hexagonal structure and NaCl-type face-centered cubic structure in each layer can be determined.

Since the B layer and the C layer have different area ratios of hexagonal to face-centered cubic crystal structures, the measurement by TEM can determine the boundary between these layers. The area ratios of these two crystal structures are measured and the compositions are analyzed across the boundary between these layers to define the boundary region between the B and C layers and to determine the average thickness of each layer (the average thickness is measured at five or more sites). The average contents ($X_B$, $X_C$) of Al in these layer can be determined by averaging the analytical results obtained from multiple line scanning (e.g., five or more lines) of electron beams across the thickness of the coating segment by Auger electron spectroscopy (AES).

The boundary between layers A and B can be defined and the average thicknesses of the A and B layers can be determined by performing scanning of multiple (e.g., five or more) lines of electron beams across the thickness of the coating segment including the A and B layers in the cross-section by AES (the average thickness is measured at five or more sites).

The average C content Z, $Y_B$, and $Y_C$ in the A, B, and C layers, respectively, can be determined by secondary ion mass spectrometry (SIMS) as follows: An observation area of 70 $\mu$m by 70 $\mu$m on the surface of the coating segment is irradiated with ion beams, and surface analysis by analytical ion beams and etching by sputtering ion beams are alternately repeated to determine the contents along the depth or thickness of the coating segment. In detail, the content is measured every 0.01 $\mu$m or less over a depth of at least 0.05 $\mu$m starting from a depth of 0.02 $\mu$m or more from the surface of the each layer and the average content is determined. This procedure is repeated at five or more sites by irradiation with ion beams in addition to the aforementioned measurement range to determine the average content of C in each layer.

In the same way, the ratio of $(Al_{XB}Ti_{1-XB})$ to $(C_{YB}N_{1-YB})$ can be determined from the average contents of Al, Ti, and N in each layer by SIMS.

(2) X-ray analysis

In the results of the X-ray diffractometry of the coating segment, the ratio, Ih(100)/[Ic(111)+Ic(200)] of the sum of the diffraction intensities of the 111 and 200 diffraction lines of crystal grains with a face-centered cubic crystal structure of a NaCl type to the 100 diffraction line of crystal grains with a hexagonal crystal structure of a wurtzite type, should more preferably satisfy the following relation: $0.1 \leq Ih(100)/[Ic (111)+Ic(200)] \leq 0.4$, where Ic(111) represents the diffraction intensity of the 111 diffraction line of crystal grains with a face-centered cubic crystal structure of a NaCl type, Ic(200) represents the diffraction intensity of the 200 diffraction line of a NaCl type, and Ih(100) is the diffraction intensity of the 100 diffraction line of crystal grains with a hexagonal crystal structure of a wurtzite type, for the following reasons:

In the case that the ratio is less than 0.1, the coating segment may be susceptible to brittle fracture due to impact during cutting, for example. In the case that the ratio exceeds 0.4, wear resistance may be significantly reduced.

The 100, 111, and 200 diffraction lines are not observed independently for each layer, but are observed as superposition of the diffraction lines of these layers in the X-ray diffractometry of the coating segment including the A, B, and C layers (including the outermost surface layer if present).

The intensity Ih(100) is measured with a 100 diffraction line of AlN for the following reason: The peak of the 100 diffraction line of (AlTi)CN with a wurtzite-type hexagonal structure appears at substantially the same position as the 100 diffraction line of AlN. In the X-ray diffraction pattern, the 111 and 200 diffraction lines of crystal grains with NaCl-type face-centered cubic crystal structure may appear separately in the B and C layers. In such cases, the total intensity of these peaks in the B layer and the C layer is defined as "Ic(111)+Ic(200)".

The 100, 111, and 200 diffraction lines refer to the diffraction peaks in the hexagonal (100) plane of the wurtzite-type structure, the face-centered cubic (111) plane of the NaCl-type structure, and the face-centered cubic (200) plane of the NaCl-type structure, respectively.

The Conditions for the measurement are as follows:

Scanning axis: $2\theta$-$\theta$
X-ray source: Cu-Ka ray (1.541862Å)
Detector: 0-dimensional detector (scintillation counter)
Tube voltage: 45 kV
Tube current: 40 mA
Incident optics: Use of mirrors
Receiving optics: Use of analyzer crystal (PW3050/60)
Steps: 0.03°.
Accumulation time: 2 seconds
Scanning range ($2\theta$): 10° to 120°

8. Production

The coating segment of the coated tool of the embodiment may be produced by chemical vapor deposition, for example, under the following process conditions:

(1) Production of A layer

The A Layer is produced under the following manufacturing conditions 1) or 2), depending on its type.

(1) Manufacturing condition 1

Deposition of TiN layer

Composition of reaction gas (volume %): 3.0 to 6.0% $TiCl_4$, 25.0 to 35.0% $N_2$, the balance being $H_2$;

Pressure of reaction atmosphere: 4.0 to 12.0 kPa; and
Temperature of reaction atmosphere: 780 to 900°C

(2) Manufacturing condition 2

Deposition of TiCN layer

Composition of reaction gas (volume %): 3.0 to 6.0% $TiCl_4$, 15.0 to 30.0% $N_2$, 0.6 to 2.0% $CH_4$ or $CH_3CN$, the balance being $H_2$;

Pressure of reaction atmosphere: 7.0 to 12.0 kPa; and
Temperature of reaction atmosphere: 780 to 900°C

(2) Production of B layer

Composition of reaction gas (volume %):

Gas Group B1: 0.01 to 0.02% $TiCl_4$, 0.04 to 0.10% $AlCl_3$, 0.0 to 10.0% $N_2$, 0.0 to 0.5% $C_2H_4$, the balance being $H_2$
Gas Group B2: 1.0 to 3.0% $NH_3$, 25.0 to 35.5% $H_2$;
Pressure of reaction atmosphere: 4.0 to 5.0 kPa;
Temperature of reaction atmosphere: 800 to 900°C;
Supply cycle: 1 to 5 seconds;
Gas supply time per cycle: 0.15 to 0.25 seconds
Phase difference between gas supply of gas group B1 and gas group B2: 0.10 to 0.20 seconds

(3) Production of C layer

Composition of reaction gas (volume %):

Gas Group C1: 0.01 to 0.03% $TiCl_4$, 0.02 to 0.09% $AlCl_3$, 0.0 to 10.0% $N_2$, 0.0 to 0.5% $C_2H_4$, the balance being $H_2$;
Gas Group C2: 0.1 to 0.8% $NH_3$, 25.0 to 35.0% $H_2$;
Pressure of reaction atmosphere: 4.0 to 5.0 kPa;
Temperature of reaction atmosphere: 700 to 850°C;
Supply cycle: 1 to 5 seconds;
Gas supply time per cycle: 0.15 to 0.25 seconds
Phase difference between gas supply of gas group C1 and gas group C2: 0.10 to 0.2 seconds.

Examples

Examples will now be described.
Insert cutting tools including WC-based cemented carbide substrates will be exemplified. The substrates may be composed of the materials described above. The shape of the tool shape may be of a drill or end mill.
WC, TiC, TaC, NbC, $Cr_3C_2$, and Co raw powders were prepared, and these raw powders were compounded as shown in Table 1. After wax was added, the mixture was mixed with acetone for 24 hours in a ball mill, and was then dried under reduced pressure. The dried mixture was pressed and formed at a pressure of 98 MPa into a green compact with a predetermined shape, which was then sintered under vacuum at a predetermined temperature of 1420°C for 1 hour under a vacuum of 5 Pa. WC-based cemented carbide Substrates A to C with JOMU 140715ZZER-M(Product shape of Mitsubishi Materials Corp.) insert shapes were thereby produced.
A, B, and C layers were deposited in sequence on the surface of each of Substrates A to C in accordance with the conditions shown in Tables 2 to 4, to yield Example coated tools 1 to 8 (hereinafter referred to as Examples 1 to 8) shown in Table 5.
For comparison, A, B, and C layers were also deposited in sequence on the surface of each of Substrates A to C in accordance with the conditions shown in Tables 2 to 4, respectively, to yield comparative example coated tools 1 to 8 (hereinafter referred to as Comparative examples 1 to 8) shown in Table 6.

[Table 1]

| Type | | Composition (mass%) | | | | | |
|---|---|---|---|---|---|---|---|
| | | Co | TiC | TaC | NbC | $Cr_3C_2$ | WC |
| Substrate | A | 7.5 | 0.0 | 0.0 | 0.0 | 0.3 | Balance |
| | B | 5.0 | 0.3 | 0.8 | 0.2 | 0.2 | Balance |
| | C | 8.0 | 0.0 | 0.0 | 0.0 | 0.7 | Balance |

[Table 2]

| Conditions of manufacture of A layer | | | | | | | | | |
|---|---|---|---|---|---|---|---|---|---|
| Step | Symbol of formation | Layer to be formed | Composition of gas group A (vol%) | | | | | Reaction conditions of gaseous phase | |
| | | | $TiCl_4$ | $N_2$ | $CH_4$ | $CH_3CN$ | $H_2$ | Pressure (kPa) | Temp. (°C) |
| Example step of deposition | A | TiCN | 5.1 | 19.7 | 0.0 | 1.2 | Balance | 9.1 | 820 |
| | B | TiN | 3.0 | 27.6 | 0.0 | 0.0 | Balance | 9.9 | 900 |
| | C | TiCN | 4.3 | 18.9 | 1.0 | 0.0 | Balance | 7.9 | 830 |
| | D | TiN | 6.0 | 25.0 | 0.0 | 0.0 | Balance | 10.4 | 870 |
| | E | TiN | 3.5 | 28.4 | 0.0 | 0.0 | Balance | 10.5 | 780 |
| | F | TiCN | 5.6 | 29.5 | 0.0 | 1.7 | Balance | 11.4 | 800 |
| | G | TiN | 3.5 | 32.9 | 0.0 | 0.0 | Balance | 5.4 | 880 |
| | H | TiCN | 4.6 | 17.0 | 1.5 | 0.0 | Balance | 10.6 | 820 |
| Comparative Example step of deposition | a | No step of formation of A layer | | | | | | | |
| | b | TiCN | 5.8 | 28.0 | 0.0 | 1.9 | Balance | 7.0 | 790 |
| | c | TiN | 5.1 | 27.9 | 0.0 | 0.0 | Balance | 10.0 | 840 |
| | d | TiN | 4.9 | 30.1 | 0.0 | 0.0 | Balance | 4.7 | 860 |
| | e | TiN | 3.8 | 27.9 | 0.0 | 0.0 | Balance | 10.0 | 820 |
| | f | TiCN | 5.5 | 27.1 | 1.6 | 0.0 | Balance | 10.1 | 850 |
| | g | TiN | 3.6 | 29.3 | 0.0 | 0.0 | Balance | 11.6 | 790 |
| | h | TiCN | 5.0 | 25.4 | 1.6 | 0.0 | Balance | 10.0 | 900 |

[Table 3]

| | | Conditions of manufacture of B layer | | | | | | | | | | | | |
|---|---|---|---|---|---|---|---|---|---|---|---|---|---|---|
| Step | Symbol of formation | Gas group B1 | | | | | Gas group B2 | | Conditions of supply of Gas groups B1 and B2 | | | Reaction conditions of gaseous phase | | |
| | | Composition (vol %) | | | | | Composition (vol %) | | | | | | | |
| | | $TiCl_4$ | $AlCl_3$ | $N_2$ | $C_2H_4$ | $H_2$ | $NH_3$ | $H_2$ | Cycle of supply (sec) | Supply time per cycle (sec) | Difference in phase of supply between gas groups B1 and B2 (sec) | Pressure (kPa) | Temp. (℃) |
| Example step of deposition | A | 0.01 | 0.06 | 6.9 | 0.0 | Balance | 1.0 | 34.9 | 4 | 0.20 | 0.11 | 4.0 | 800 |
| | B | 0.02 | 0.09 | 5.4 | 0.1 | Balance | 1.3 | 28.9 | 4 | 0.24 | 0.16 | 4.3 | 850 |
| | C | 0.01 | 0.06 | 8.0 | 0.1 | Balance | 2.8 | 29.4 | 3 | 0.21 | 0.15 | 4.6 | 900 |
| | D | 0.01 | 0.10 | 9.8 | 0.5 | Balance | 1.3 | 31.2 | 5 | 0.18 | 0.14 | 4.4 | 850 |
| | E | 0.02 | 0.08 | 5.7 | 0.1 | Balance | 2.0 | 25.0 | 3 | 0.21 | 0.11 | 4.3 | 810 |
| | F | 0.01 | 0.05 | 4.6 | 0.3 | Balance | 2.7 | 28.9 | 1 | 0.22 | 0.17 | 4.4 | 870 |
| | G | 0.01 | 0.04 | 0.0 | 0.5 | Balance | 3.0 | 29.6 | 3 | 0.21 | 0.14 | 5.0 | 860 |
| | H | 0.01 | 0.09 | 8.4 | 0.0 | Balance | 1.5 | 35.5 | 1 | 0.17 | 0.11 | 4.7 | 830 |
| Comparative Example step of deposition | a | 0.01 | 0.10 | 9.5 | 0.3 | Balance | 1.9 | 27.0 | 2 | 0.18 | 0.11 | 4.9 | 830 |
| | b | 0.01 | 0.05 | 8.8 | 0.0 | Balance | 0.1 | 32.1 | 3 | 0.24 | 0.12 | 4.3 | 890 |
| | c | 0.02 | 0.08 | 3.5 | 0.3 | Balance | 1.7 | 32.3 | 5 | 0.19 | 0.14 | 4.4 | 950 |
| | d | 0.01 | 0.07 | 2.4 | 2.1 | Balance | 2.8 | 25.0 | 2 | 0.20 | 0.15 | 4.1 | 840 |
| | e | No step of formation of B layer | | | | | | | | | | | |
| | f | 0.03 | 0.06 | 4.6 | 0.5 | Balance | 1.3 | 34.8 | 3 | 0.17 | 0.12 | 4.2 | 820 |
| | g | 0.01 | 0.07 | 5.4 | 0.2 | Balance | 2.7 | 32.2 | 4 | 0.21 | 0.12 | 4.2 | 850 |
| | h | 0.03 | 0.18 | 2.9 | 0.2 | Balance | 3.0 | 26.6 | 5 | 0.25 | 0.16 | 4.2 | 890 |

[Table 4]

| Step | Symbol of formation | Conditions of manufacture of C layer | | | | | | | | | | | |
|---|---|---|---|---|---|---|---|---|---|---|---|---|---|
| | | Gas group C1 | | | | | Gas group C2 | | Conditions of supply of Gas groups C1 and C2 | | | Reaction conditions of gaseous phase | |
| | | Composition (vol %) | | | | | Composition (vol %) | | | | | | |
| | | $TiCl_4$ | $AlCl_3$ | $N_2$ | $C_2H_4$ | $H_2$ | $NH_3$ | $H_2$ | Cycle of supply (sec) | Supply time per cycle (sec) | Difference in phase of supply between gas groups C1 and C2 (sec) | Pressure (kPa) | Temp. (°C) |
| Comparative Example of deposition | A | 0.01 | 0.05 | 9.2 | 0.4 | Balance | 0.6 | 25.9 | 2 | 0.22 | 0.14 | 4.1 | 820 |
| | B | 0.03 | 0.06 | 2.6 | 0.0 | Balance | 0.2 | 34.9 | 4 | 0.23 | 0.11 | 4.3 | 850 |
| | C | 0.01 | 0.02 | 7.2 | 0.2 | Balance | 0.5 | 34.2 | 4 | 0.16 | 0.11 | 4.0 | 810 |
| | D | 0.01 | 0.09 | 4.4 | 0.4 | Balance | 0.2 | 25.0 | 1 | 0.20 | 0.12 | 4.5 | 700 |
| | E | 0.02 | 0.07 | 4.5 | 0.4 | Balance | 0.7 | 29.8 | 1 | 0.21 | 0.13 | 5.0 | 790 |
| | F | 0.01 | 0.05 | 6.4 | 0.1 | Balance | 0.8 | 26.3 | 5 | 0.18 | 0.12 | 4.2 | 770 |
| | G | 0.01 | 0.03 | 8.6 | 0.4 | Balance | 0.5 | 33.9 | 4 | 0.23 | 0.17 | 4.8 | 840 |
| | H | 0.01 | 0.08 | 0.0 | 0.5 | Balance | 0.1 | 25.4 | 4 | 0.20 | 0.10 | 4.5 | 760 |
| Comparative Example step of deposition | a | 0.01 | 0.05 | 5.6 | 0.2 | Balance | 0.8 | 27.0 | 1 | 0.15 | 0.11 | 4.3 | 700 |
| | b | 0.01 | 0.01 | 5.3 | 0.1 | Balance | 0.1 | 32.4 | 1 | 0.23 | 0.17 | 4.1 | 700 |
| | c | 0.01 | 0.04 | 5.2 | 0.1 | Balance | 0.3 | 32.7 | 3 | 0.18 | 0.11 | 4.1 | 950 |
| | d | 0.01 | 0.02 | 6.8 | 0.4 | Balance | 3.0 | 25.3 | 1 | 0.22 | 0.12 | 4.1 | 820 |
| | e | 0.01 | 0.07 | 7.2 | 2.2 | Balance | 0.2 | 31.5 | 3 | 0.16 | 0.12 | 4.2 | 740 |
| | f | 0.03 | 0.08 | 6.3 | 0.1 | Balance | 0.8 | 31.7 | 2 | 0.20 | 0.15 | 4.2 | 810 |
| | g | 0.01 | 0.12 | 7.8 | 0.1 | Balance | 0.3 | 29.9 | 5 | 0.19 | 0.15 | 4.4 | 790 |
| | h | 0.05 | 0.05 | 3.5 | 0.3 | Balance | 0.7 | 27.2 | 5 | 0.17 | 0.14 | 4.6 | 740 |

[Table 5]

EP 4 678 315 A1

13

| Type | | Symbol of tool substrate | Symbol of formation | Average thickness ($\mu$m) | A layer | | B layer $(Al_{xB}Ti_{1-xB})(C_{yB}N_{1-yB})$ | | | | C layer $(Al_{xC}Ti_{1-xC})(C_{yC}N_{1-yC})$ | | | | $Ih(100)/[Ic(111)+Ic(200)]$ |
|---|---|---|---|---|---|---|---|---|---|---|---|---|---|---|---|
| | | | | | Average thickness ($\mu$m) | Composition of layer | Average thickness ($\mu$m) | Average composition | | Area (%) of crystal grains with wurtzite-type hexagonal crystal structure | Average thickness ($\mu$m) | Average composition | | Area (%) of crystal grains with wurtzite-type hexagonal crystal structure | |
| | | | | | | | | XB | YB | | | XC | YC | | |
| Example | 1 | A | A | 12.5 | 0.8 | $TiC_{0.55}N_{0.45}$ | 0.5 | 0.83 | 0.00 | 30 | 11.2 | 0.90 | 0.04 | 24 | 0.8 |
| | 2 | B | B | 0.7 | 0.1 | TiN | 0.1 | 0.84 | 0.01 | 39 | 0.5 | 0.69 | 0.00 | 13 | 0.0 |
| | 3 | C | C | 5.8 | 1.2 | $TiC_{0.31}N_{0.69}$ | 0.2 | 0.89 | 0.01 | 89 | 4.4 | 0.80 | 0.01 | 25 | 0.3 |
| | 4 | A | D | 20.7 | 0.3 | TiN | 0.4 | 0.95 | 0.04 | 40 | 20.0 | 0.86 | 0.04 | 5 | 0.3 |
| | 5 | B | E | 21.0 | 2.0 | TiN | 0.3 | 0.80 | 0.01 | 42 | 18.7 | 0.75 | 0.03 | 16 | 0.9 |
| | 6 | C | F | 19.3 | 0.8 | $TiC_{0.59}N_{0.41}$ | 0.1 | 0.91 | 0.02 | 90 | 18.4 | 0.78 | 0.00 | 19 | 1.0 |
| | 7 | A | G | 4.7 | 0.6 | TiN | 0.1 | 0.80 | 0.04 | 85 | 4.0 | 0.65 | 0.03 | 17 | 0.2 |
| | 8 | B | H | 18.1 | 0.2 | $TiC_{0.27}N_{0.73}$ | 0.4 | 0.95 | 0.00 | 44 | 17.5 | 0.84 | 0.04 | 11 | 0.6 |

[Table 6]

| Type | Symbol of tool substrate | Symbol of formation | Average thickness (μm) | A layer Average thickness (μm) | A layer Composition of layer | B layer (Al$_{xB}$Ti$_{1-xB}$)(C$_{yB}$N$_{1-yB}$) Average thickness (μm) | B layer Average composition XB | B layer Average composition YB | B layer Area (%) of crystal grains with wurtzite-type hexagonal crystal structure | C layer (Al$_{xC}$Ti$_{1-xC}$)(C$_{yC}$N$_{1-yC}$) Average thickness (μm) | C layer Average composition XC | C layer Average composition YC | C layer Area (%) of crystal grains with wurtzite-type hexagonal crystal structure | Ih(100)/[Ic(111)+Ic(200)] | |
|---|---|---|---|---|---|---|---|---|---|---|---|---|---|---|---|
| 1 | A | a | 5.6 | - | - | 0.1 | 0.98 | 0.03 | 49 | 5.5 | 0.84 | 0.02 | 12 | 0.2 | Comparative Example |
| 2 | B | b | 9.0 | 1.4 | TiC$_{0.58}$N$_{0.42}$ | 0.3 | 0.91 | 0.00 | 8 | 7.3 | 0.61 | 0.01 | 37 | 0.7 | Comparative Example |
| 3 | C | c | 0.4 | 0.1 | TiN | 0.1 | 0.82 | 0.02 | 45 | 0.2 | 0.81 | 0.01 | 47 | 0.0 | Comparative Example |
| 4 | A | d | 16.4 | 0.4 | TiN | 0.1 | 0.89 | 0.21 | 78 | 15.9 | 0.83 | 0.03 | 42 | 1.9 | Comparative Example |
| 5 | B | e | 16.9 | 0.4 | TiN | - | - | - | - | 16.5 | 0.87 | 0.22 | 11 | 0.5 | Comparative Example |
| 6 | C | f | 27.7 | 2.0 | TiC$_{0.37}$N$_{0.63}$ | 0.4 | 0.64 | 0.04 | 4 | 25.3 | 0.74 | 0.01 | 16 | 1.2 | Comparative Example |
| 7 | A | g | 25.3 | 1.3 | TiN | 5.9 | 0.91 | 0.02 | 79 | 18.1 | 0.96 | 0.01 | 38 | 3.3 | Comparative Example |
| 8 | B | h | 16.0 | 4.1 | TiC$_{0.32}$N$_{0.68}$ | 0.2 | 0.86 | 0.02 | 19 | 11.7 | 0.53 | 0.02 | 3 | 0.1 | Comparative Example |

In Table 6, symbol "-" indicates no applicable items.

Each of the cutting tools of Examples 1 to 8 and Comparative Examples 1 to 8 were clamped to the tip of a cutter made of tool steel with a cutter diameter of 63 mm with a fixture, and the following dry-type front face milling cutting tests were conducted on stainless steel until defects occurred. Table 7 shows the results of the cutting tests.

Cutting test: Dry-type front face milling

Workpiece: Stainless steel (SUS304) block material: 45 mm wide
Cutting speed: 160 m/min
Depth of cut: 1.5 mm
Feed: 1.5 mm/edge

[Table 7]

| Type | | Maximum processing time (min) | Type | | Maximum processing time (min) |
|---|---|---|---|---|---|
| Examples | 1 | 5.8 | Comparative Examples | 1 | 2.3 |
| | 2 | 5.7 | | 2 | 2.2 |
| | 3 | 7.3 | | 3 | 2.5 |
| | 4 | 7.0 | | 4 | 2.7 |
| | 5 | 6.5 | | 5 | 1.8 |
| | 6 | 6.9 | | 6 | 1.7 |
| | 7 | 7.2 | | 7 | 1.6 |
| | 8 | 6.0 | | 8 | 1.9 |

The term "maximum machining time (minutes)" in Table 7 refers to the machining time to reach defects. Every minute after the start of the cutting test, the occurrence of chipping and delamination caused by plastic deformation were visually observed, the clearance surface wear width (including chipping) was measured, and the time to reach the utilization life (maximum machining time) was measured.

The utilization life was defined as the time when the width of the flank face wear exceeds 0.2 mm. The maximum machining time was defined as the time elapsed from the start of the test that gave a width of the flank face wear of 0.2 mm by linear approximation of the width of the flank face wear at the elapsed time (measuring time) from the start of the test that exceeded 0.2 mm and the width of the flank face wear at the measuring time at one previous measuring time.

Table 7 evidentially demonstrates that Examples all have a long maximum machining time and high durability even in high-feed cutting of stainless steel. In contrast, Comparative examples all have short maximum machining times and reach the end of their service life in a short time.

It is noted that the surface coated cutting tool of the present invention is expected to demonstrate high durability even when used for cutting materials, such as Ni-based heat-resistant alloys and Ti alloys, which also have high weldability and apply large thermal and mechanical loads to the cutting edge, in addition to stainless steel.

The foregoing disclosed embodiments are in all respects illustrative only and are not restrictive. The scope of the invention is indicated by the claims, not the embodiments, and is intended to include all modifications within the meaning and scope of the claims and equivalents.

[Reference Numerals]

1    substrate
2    A layer

3   B layer
4   C layer
5   outermost layer
6   coating segment

**Claims**

1.  A surface coated cutting tool comprising a substrate and a coating segment on the surface of the substrate, wherein

    (a) the coating segment comprises an A layer, a B layer, and a C layer, in contact with each other in order from the surface of the substrate to the surface of the tool, and the sum of the average thicknesses of these three layers ranges from 0.7 to 21.0 $\mu$m,
    (b) the A layer has an average thickness in a range of 0.1 to 2.0 $\mu$m and contains nitride or carbonitride of Ti,
    (c) the B layer has an average thickness in a range of 0.1 to 0.5 $\mu$m, has an average composition represented by $(Al_{XB}Ti_{1-XB})(C_{YB}N_{1-YB})$ (where $0.80 \leq XB \leq 0.95$ and $0.00 \leq YB < 0.05$), and contains at least 30 area % crystal grains having a wurtzite-type hexagonal crystal structure and the balance being crystal grains having a NaCl-type face-centered cubic crystal structure, and
    (d) the C layer has an average thickness in a range of 0.5 to 20.0 $\mu$m, has an average composition represented by $(Al_{XC}Ti_{1-XC})(C_{YC}N_{1-YC})$ (where $0.65 \leq XC \leq 0.90$ and $0.00 \leq YC < 0.05$), and contains 5 to 25 area % crystal grains having a wurtzite-type hexagonal crystal structure and the balance being crystal grains having a NaCl type face-centered cubic crystal structure.

2.  The surface coated cutting tool according to claim 1, wherein, in the coating segment, the intensity Ic(111) of the 111 diffraction line and the intensity Ic(200) of the 200 diffraction line of the crystal grains of the NaCl type face-centered cubic crystal structure, and the intensity Ih(100) of the 100 diffraction line of the crystal grains of the wurtzite-type hexagonal crystal structure satisfy the relation:

$$0.1 \leq Ih(100)/[Ic(111)+Ic(200)] \leq 0.4.$$

[Fig. 1]

## INTERNATIONAL SEARCH REPORT

| International application No. |
| --- |
| **PCT/JP2024/007736** |

| A. | CLASSIFICATION OF SUBJECT MATTER |
| --- | --- |

*B23B 27/14*(2006.01)i; *C23C 16/30*(2006.01)i
FI:   B23B27/14 A; C23C16/30

According to International Patent Classification (IPC) or to both national classification and IPC

| B. | FIELDS SEARCHED |
| --- | --- |

Minimum documentation searched (classification system followed by classification symbols)

B23B27/14; B23C5/00; B23B51/00; C23C16/30

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | WO 2020/138304 A1 (MITSUBISHI MATERIALS CORPORATION) 02 July 2020 (2020-07-02)<br>        paragraphs [0070]-[0080], tables 10, 11 | 1-2 |
| A | WO 2018/047733 A1 (SUMITOMO ELECTRIC HARDMETAL CORP.) 15 March 2018 (2018-03-15)<br>        paragraphs [0047]-[0067] | 1-2 |
| A | JP 2015-208845 A (MITSUBISHI MATERIALS CORPORATION) 24 November 2015 (2015-11-24) | 1-2 |
| A | JP 2015-47644 A (MITSUBISHI MATERIALS CORPORATION) 16 March 2015 (2015-03-16) | 1-2 |
| A | WO 2021/170824 A1 (AB SANDVIK COROMANT) 02 September 2021 (2021-09-02) | 1-2 |

☑ Further documents are listed in the continuation of Box C.       ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **02 April 2024** | **16 April 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

| International application No. |
|---|
| **PCT/JP2024/007736** |

### C. DOCUMENTS CONSIDERED TO BE RELEVANT

| Category* | Citation of document, with indication, where appropriate, of the relevant passages | Relevant to claim No. |
|---|---|---|
| P, A | JP 2023-101873 A (MITSUBISHI MATERIALS CORPORATION) 24 July 2023 (2023-07-24)<br>table 6, comparative example 6 | 1-2 |

Form PCT/ISA/210 (second sheet) (July 2022)

## INTERNATIONAL SEARCH REPORT
### Information on patent family members

International application No.

**PCT/JP2024/007736**

| Patent document cited in search report | | | Publication date (day/month/year) | Patent family member(s) | | | Publication date (day/month/year) |
|---|---|---|---|---|---|---|---|
| WO | 2020/138304 | A1 | 02 July 2020 | US | 2022/0111446 | A1 | |
| | | | | paragraphs [0168]-[0182], tables 10, 11 | | | |
| | | | | EP | 3903974 | A1 | |
| | | | | CN | 113474111 | A | |
| WO | 2018/047733 | A1 | 15 March 2018 | US | 2019/0232386 | A1 | |
| | | | | paragraphs [0054]-[0076] | | | |
| | | | | EP | 3511097 | A1 | |
| JP | 2015-208845 | A | 24 November 2015 | (Family: none) | | | |
| JP | 2015-47644 | A | 16 March 2015 | (Family: none) | | | |
| WO | 2021/170824 | A1 | 02 September 2021 | JP | 2023-515102 | A | |
| | | | | US | 2023/0093032 | A1 | |
| | | | | EP | 3872222 | A1 | |
| | | | | CN | 115038811 | A | |
| | | | | KR | 10-2022-0147589 | A | |
| | | | | BR | 112022014881 | A | |
| JP | 2023-101873 | A | 24 July 2023 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023034690 A
- JP 6349581 B

- JP 2020104255 A